# EUROPÄISCHE PATENTSCHRIFT

(11) **EP 1 202 852 B1**
(45) Veröffentlichungstag und Bekanntmachung des Hinweises auf die Patenterteilung: **04.06.2003**
(21) Anmeldenummer: 00960326.7
(22) Anmeldetag: 28.07.2000
(51) Int. Cl.: B29C 45/14, H05K 5/00

(54) **DICHTE LEITERDURCHFÜHRUNG DURCH KUNSTSTOFFWANDUNG**
TIGHT CONDUCTOR LEADTHROUGH FOR A PLASTIC WALL
TRAVERSEE ETANCHE DE CONDUCTEUR A TRAVERS UNE PAROI EN MATIERE SYNTHETIQUE

(30) Priorität: 03.08.1999 DE 19936370
(43) Veröffentlichungstag der Anmeldung: 08.05.2002
(73) Patentinhaber: SIEMENS AKTIENGESELLSCHAFT, 80333 München (DE)
(72) Erfinder: SMIRRA, Karl, D-83512 Wasserburg (DE)
(86) Internationale Anmeldenummer: DE0002504
(87) Internationale Veröffentlichungsnummer: WO01008865

(56) Entgegenhaltungen:
- DE-A- 3 308 332
- DE-A- 4 101 361
- DE-A- 4 330 977
- DE-A- 19 515 622
- DE-B- 1 161 969
- US-A- 5 620 344
- US-A- 5 728 964
- US-A- 5 879 610

## Beschreibung

Die Erfindung betrifft eine Anordnung zum dichten Durchführen eines elektrischen Leiters durch eine Kunststoffwandung nach den Oberbegriffen der Ansprüche 1 und 7 sowie ein Verfahren zur Herstellung einer derartigen Durchführung nach dem Oberbegriff des Anspruchs 9.

Bei Kunststoffgehäusen stellt sich in vielen technischen Anwendungsfällen die Aufgabe, elektrische Leiter dicht durch eine Wandung des Gehäuses hindurchzuführen.

In diesem Zusammenhang ist aus dem U.S.-Patent 5,728,964 bereits bekannt, Leiter als Einpreßstifte mit einem Verzahnungsprofil im Einpreßbereich zu realisieren und durch Bohrungen in der Kunststoffwandung hindurch zu stecken. Nachteilig an dieser Lösung ist der hohe Montageaufwand und auch die Tatsache, daß Kontaktierungsstrukturen an dem durchgesteckten Ende des Einpreßstiftes erst nach dem Durchstecken angebracht werden können.

Eine weitere Möglichkeit zur Durchführung von Leitern durch Kunststoffgehäusewände besteht darin, die Leiter bereits bei der Herstellung der Wandung in diese einzubetten. Die deutsche Patentanmeldung DE 195 15 622 A1 beschreibt ein Steuermodul für ein Kraftfahrzeug, bei dem elektrische Leiter in Form eines Stanzgitters durch Umspritzen mit Kunststoff in die Gehäusewandung integriert werden. Dieses Verfahren ist ausgesprochen gut für die Serienfertigung geeignet und ermöglicht die Herstellung kostengünstiger Leiterdurchführungen. Problematisch kann jedoch die Erzielung einer für die praktischen Erfordernisse ausreichenden Dichtigkeit der Durchführung sein. Ursache hierfür ist, daß bei Temperaturänderungen bedingt durch unterschiedliche Wärmeausdehnungskoeffizienten des metallischen Leiters und des umspritzten Kunststoffgehäuses die Adhäsion zwischen Leiter und Kunststoff bei Temperaturänderungen aufreißen kann, was zur Undichtigkeit des Gehäuses führt.

Speziell beim Einsatz derartiger umspritzter Leiterdurchführungen in integrierten Motor- oder Getriebesteuergeräten liegen erschwerte Bedingungen vor, da solche Gerätemodule in einem weiten Temperaturbereich betrieben werden und über Jahre hinweg dicht bleiben müssen. Hinzu kommt, daß eine extrem hohe Ausfallsicherheit gefordert ist, da bei einer Reparatur die betreffende Baugruppe (Motor oder Getriebe) geöffnet werden muß, was mit erheblichem Aufwand und Kosten verbunden ist.

In der den nächstliegenden Stand der Technik repräsentierenden deutschen Patentschrift DE 33 08 332 C2 ist eine druckund vakuumdichte Durchführung beschrieben, welche bei großen Temperaturwechselbeanspruchungen einsetzbar ist. Die Durchführung weist einen als einachsiges Rundteil ausgebildeten Leiter auf, welcher durch einen Gießharzblock geführt ist. An dem Abschnitt des Leiters, der in dem Gießharzblock verläuft, sind Umfangsnuten vorgesehen. Diese Formgebung dient sowohl der Verbundfestigkeit als auch der Dichtheit der Durchführung.

In der deutschen Offenlegungsschrift DE 43 30 977 A1 ist ein Gehäuse aus Kunststoff beschrieben, durch welches elektrische Leiter durchgeführt sind. Die Leiter sind im Bereich ihres Austritts aus der Gehäusewand in den Innenraum des Gehäuses abgewinkelt und werden in diesem Bereich von einer Dichtmasse umgeben, welche in eine am Leiteraustritt vorgesehene Ausnehmung gefüllt ist.

In der deutschen Patentschrift DE-AS 1 161 969 ist eine Anordnung zum Abdichten von elektrischen Leitern in einem Kopfteil beschrieben. Der Leiter weist eine stufenförmige Umbiegung auf.

Der Erfindung liegt die Aufgabe zugrunde, eine kostengünstig realisierbare Anordnung zum Durchführen eines metallischen Leiters durch eine Kunststoffwandung zu schaffen, die insbesondere auch beim Auftreten von großen Temperaturänderungen gute Dichtigkeitseigenschaften zeigt. Ferner zielt die Erfindung darauf ab, ein kostengünstig ausführbares Verfahren zur Herstellung einer derartigen Durchführungsanordnung anzugeben.

Zur Lösung der Erfindung sind die Merkmale der unabhängigen Ansprüche vorgesehen.

Die der Erfindung zugrundeliegende Idee besteht darin, die Unterschiedlichkeit der thermomechanischen Materialeigenschaften zwischen Leiter und Kunststoffmaterial, die bei bekannten Anordnungen zum Entstehen der Undichtigkeiten führt, durch eine geeignete Formgebung des Leiters zur Erzielung von Abdichtkräften auszunutzen. Ein erster Aspekt der Erfindung besteht darin, zu diesem Zweck einen Leiter mit einem gebogenen Verlauf vorzusehen. Das Kunststoffmaterial zwängt den Leiter unter Ausübung der entgegengerichteten Abdichtkräfte wenigstens in einem Abschnitt des Durchführungswegs ein, wodurch der Durchführungsweg abgedichtet wird. Selbstverständlich können auch mehrere solche "Dichtstellen" im Durchführungsweg realisiert sein und die Lage der Dichtstelle(n) kann sich mit der Umgebungstemperatur ändern.

Vorzugsweise umfaßt der Verlauf des Leiters in einer ersten Ebene mindestens zwei entgegengesetzt gekrümmte Umbiegungen. Dadurch wird im Verbindungsbereich der beiden Umbiegungen eine Abdichtung von im wesentlichen senkrecht zu der ersten Ebene verlaufenden Leiterwänden erreicht.

Eine ebenfalls bevorzugte, weitere Möglichkeit zur Erzielung einer Abdichtung von im wesentlichen senkrecht zu der ersten Ebene orientierten Leiterwänden besteht darin, daß der Verlauf des Leiters in der ersten Ebene eine (einzige) Umbiegung umfaßt, und daß die Umbiegung in ihrem Außenbereich zumindest abschnittsweise von einem im wesentlichen starren Gegendruckelement, insbesondere einer Kapsel, umgeben ist. Auch hier wird im Bereich der Umbiegung eine Anpreßkraft an die innere Seitenwand des Leiters erzeugt. Die auf die gegenüberliegende (äußere) Leiterseitenwand einwirkende Gegenanpreßkraft wird hier - anders als bei der ersten Lösung - nicht durch eine zweite, entgegengesetzt gekrümmte Umbiegung des Leiters, sondern durch das starre Gegendruckelement erzeugt.

Zur Abdichtung von im wesentlichen parallel zu der ersten Ebene verlaufenden Leiterwände kann der Leiter mit mindestens zwei in Axialrichtung beabstandet angeordneten Paaren aus voneinander weggerichteten Dichtvorsprüngen ausgestattet sein, die sich in einer Richtung senkrecht zu der ersten Ebene erstrecken.

Ein zweiter Aspekt der Erfindung, der auch mit dem ersten Aspekt kombinierbar ist, kennzeichnet sich dadurch, daß der Leiter mit zumindest zwei unter axialem Abstand angeordneten Radialscheibenelementen versehen ist, welche an beiden Seiten mit erhabenen, radial beabstandeten Umlaufstegen versehen sind. Das Prinzip zur Erzielung der Dichtheit besteht auch hier darin, daß zwischen den beiden Radialscheibenelementen im Kunststoffmaterial und zwischen den Radialscheibenelementen ein Druckaufbau stattfindet und dadurch an den einander zugewandten Radialscheibenseiten dichte Metall-Kunststoff-Anlagebereiche entstehen.

Eine besonders zweckmäßige Variante der Erfindung kennzeichnet sich dadurch, daß mehrere Leiter in Form eines Stanzgitters zusammengefaßt sind.

Das erfindungsgemäße Verfahren weist neben seiner guten Integrierbarkeit in Serienfertigungsabläufe den Vorteil auf, daß die Leiter vor der Einbettung in das Kunststoffmaterial an ihren später aus der Wandung hervorstehenden Leiterenden bereits geeignet bearbeitet werden können, so daß eine umständliche Nachbearbeitung der Leiterenden im Gehäuseverbund entfällt.

Weitere vorteilhafte Ausgestaltungen der Erfindung sind in den Unteransprüchen angegeben.

Die Erfindung wird nachfolgend anhand von zwei Ausführungsformen unter Bezugnahme auf die Zeichnung erläutert; in dieser zeigt:
- Fig. 1: eine schematische Schnittdarstellung eines in einer Kunststoffwandung eingebetteten Leiters mit einer einzigen rechteckförmigen Umbiegung;
- Fig. 2: eine perspektivische Ansicht eines Leiters mit drei rechteckförmigen Umbiegungen gemäß einer ersten Ausführungsform der Erfindung;
- Fig. 3: eine schematische Schnittdarstellung des in einer Kunststoffwandung eingebetteten Leiters aus Fig. 2 nach Auftreten einer Temperaturerhöhung;
- Fig. 4: eine schematische Längsschnittdarstellung eines Leiterabschnitts mit drei Paaren von Dichtvorsprüngen;
- Fig. 5: eine schematische Schnittdarstellung eines in eine Kunststoffwandung eingebetteten Leiters mit einer verkapselten rechteckförmigen Umbiegung gemäß einer Variante der ersten Ausführungsform;
- Fig. 6: eine schematische Darstellung eines in einer Kunststoffwandung eingebetteten Leiters mit zwei Radialscheibenelementen gemäß einer zweiten Ausführungsform der Erfindung; und
- Fig. 7: eine schematische Darstellung eines Gehäuseabschnitts eines Kraftfahrzeug-Steuergeräts mit einer Leitungsdurchführung gemäß der in Fig. 5 dargestellten Variante der ersten Ausführungsform.

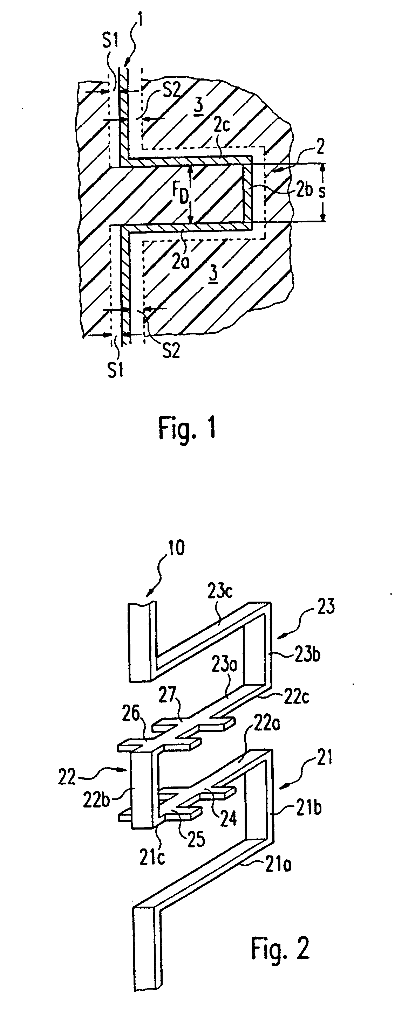

Fig. 1 dient zur Erläuterung des Grundprinzips der Erfindung am Beispiel eines Leiters 1 mit einer einzigen rechteckförmigen Umbiegung 2. Die Umbiegung 2 des Leiters wird durch die Umbiegungsschenkel 2a, 2c und den Umbiegungsstirnbereich 2b realisiert.

Es sei angenommen, daß der Leiter 1 nach einem Umspritzvorgang spaltfrei in einem Kunststoffmaterial 3 eingebettet sei. Das Kunststoffmaterial 3, beispielsweise PA66, kann einen thermischen Ausdehnungskoeffizienten α = 60 x 10⁻⁶ K⁻¹ besitzen. Der Leiter 1 besteht beispielsweise aus Cu und weist einen thermischen Ausdehnungskoeffizienten von α = 17 x 10⁻⁶ K⁻¹ auf.

Infolge einer Temperaturerhöhung würde sich der in Fig. 1 dargestellte Zustand ergeben. Aufgrund der größeren Wärmedehnung des Kunststoffes 3 bilden sich an den vor und hinter der Umbiegung 2 liegenden Längsbereichen 4a und 4b des Leiters 1 zu beiden Seiten desselben Spalte S1, S2 aus, die bei herkömmlicher, linearer Bauweise zur Undichtigkeit der Durchführung führen würden.

Durch die einzelne Umbiegung 2 wird zwar eine teilweise Abdichtung der Durchführung, nämlich eine Abdichtung des Spaltes S1 erreicht. Dem liegt zugrunde, daß die größere Wärmedehnung des Kunststoffs den Leiter 1 im konkaven Bereich der Umbiegung 2 verspreizt, d.h. hier eine Anpreßkraft (Abdichtkraft) F_{D} erzeugt. Diese Anpreßkraft F_{D} ist umso größer, je größer das Maß s ist, welches den Abstand der beiden Umbiegungsschenkel 2a, 2c bezeichnet. Im konvexen Bereich der Umbiegung 2 wird der Leiter 1 jedoch freigelegt, d.h. der Spalt S2 entsteht. Um den Spalt S2 dicht zu bekommen, sind weitere Maßnahmen erforderlich, welche in Verbindung mit den nachfolgenden Figuren erläutert werden.

Fig. 2 zeigt einen Leiter 10, der sich von dem in Fig. 1 gezeigten Leiter 1 im wesentlichen dadurch unterscheidet, daß er drei Umbiegungen 21, 22, 23 mit gegenläufigen Krümmungen aufweist. Die Schenkel der Umbiegungen 21, 22, 23 sind mit den Bezugszeichen 21a, 21c, 22a, 22c, 23a, 23c bezeichnet, wobei die Schenkel 21c, 22a der ersten und zweiten Umbiegung und die Schenkel 22c, 23a der zweiten und dritten Umbiegung zusammenfallen. Die Stirnbereiche der Umbiegungen 21, 22, 23 sind mit den Bezugszeichen 21b, 22b und 23b bezeichnet.

Der Leiter 10 ist an dem Schenkel 22a mit zwei Querstegen 24, 25 und an dem Schenkel 22c mit zwei Querstegen 26, 27 versehen. Die Querstegen 24, 25, 26, 27 liegen in einer Ebene senkrecht zu der durch die Umbiegungen 21, 22, 23 defininierten Leiterebene (erste Ebene).

Der Leiter 10 weist einen rechteckförmigen Querschnitt auf.
Er kann in einfacher Weise in gestreckter Form als Stanzteil hergestellt und nachfolgend durch Umbiegen in die in Fig. 2 dargestellte Form gebracht werden.

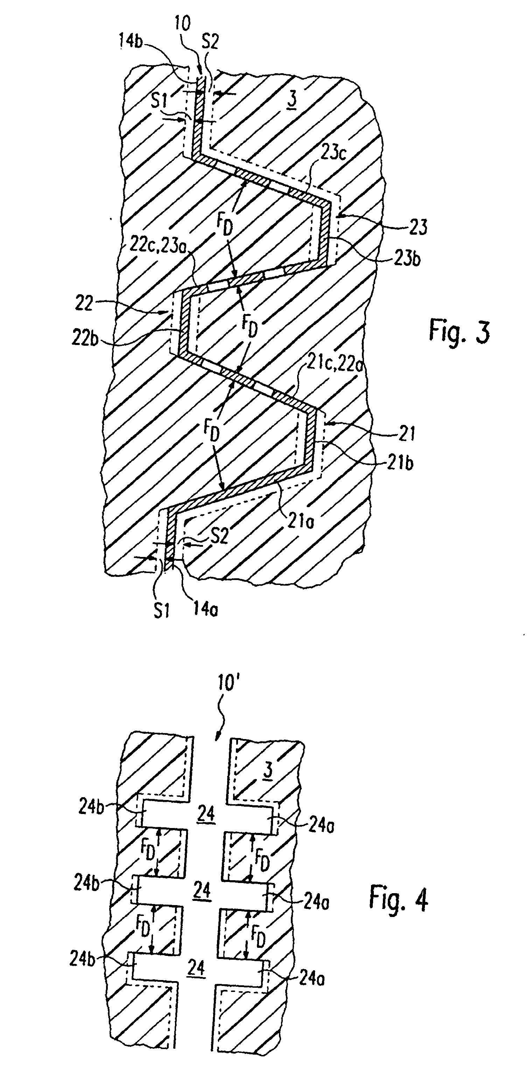

Fig. 3 zeigt eine Schnittdarstellung entlang der Leiterbahnebene (erste Ebene) des in der Kunststoffwandung 3 eingebetteten Leiters 10 nach Auftreten einer Temperaturerhöhung. Wie bereits anhand der Fig. 1 erläutert, bilden sich zu beiden Seiten der endseitigen Längsbereiche 14a, 14b des Leiters 10 Spalte S1 S2 aus. Ferner kommt es aufgrund der Materialausdehnung des Kunststoffs 3 zu einem Druckaufbau in den von den Umbiegungen 21, 22, 23 berandeten Kunststoffmaterialbereichen und zu einer Auseinanderspreizung der Schenkel 21a, 21c; 22a, 22c; 23a, 23c. Da die von den Umbiegungen 21, 22, 23 berandeten Kunststoffmaterialbereiche benachbart sind, werden die beiden Schenkel 21c, 22a und 22c, 23a beidseitig mit Abdichtkraften F_{D} beaufschlagt, d.h. es kommt im Bereich beider Schenkel zu einer beidseitigen Druckanlage der Kunststoffmaterialbereiche an den Leiter 10. Dies führt zur Abdichtung des Leiters 1 in der ersten Ebene.

Für Anwendungen ohne höchste Ansprüche an die Dichtigkeit kann die Abdichtung in der ersten Ebene bereits ausreichend sein. Zweckmäßigerweise ist jedoch auch eine Abdichtung in der (zweiten) Ebene senkrecht zur Leiterebene vorzusehen. Diese wird durch die Querstege 24, 25, 26, 27 bewerkstelligt. Sie beruht auf dem gleichen Prinzip und wird anhand von Fig. 4 erläutert. Fig. 4 zeigt einen Leiterabschnitt 10', der sich von den in der Fig. 2 dargestellten Schenkeln 21c, 22a und 22c, 23a lediglich dadurch unterscheidet, daß er nicht mit zwei, sondern mit drei Querstegen 24 versehen ist. Die Querstegenden 24a und 24b bilden jeweils benachbarte, axial beabstandete Dichtvorsprünge aus, zwischen denen sich in der bereits erläuterten Weise bei einer Temperaturerhöhung die einander entgegengesetzt gerichteten Abdichtkräfte F_{D} aufbauen, und dadurch den Durchführungsweg in der zweiten Ebene abdichten.

Den Fig. 2 bis 4 ist zu entnehmen, daß ein Leiter mit zwei entgegengesetzt gekrümmten Umbiegungen und zwei Querstegen am gemeinsamen Schenkel der beiden Umbiegungen für eine vollständige Abdichtung der Durchführung ausreichend ist. Durch Aneinanderreihung weiterer Umbiegungen und/oder Leiterabschnitten 10' mit Querstegen 24 kann die Dichtfunktionssicherheit jedoch erheblich erhöht werden.

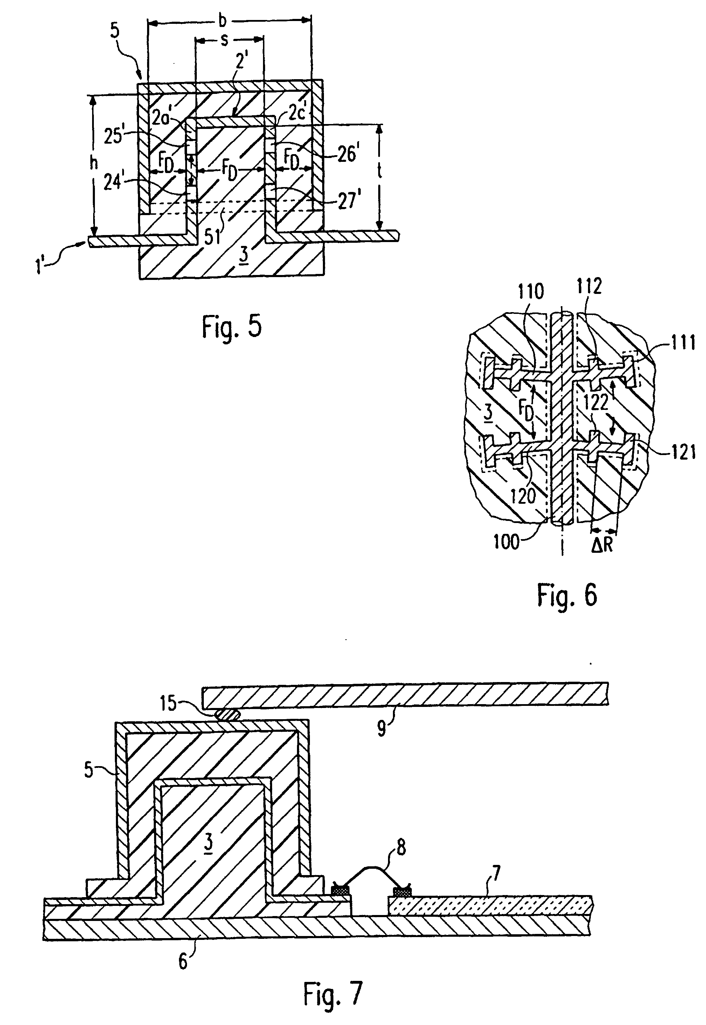

Fig. 5 zeigt eine Variante der vorstehend erläuterten ersten Ausführungsform. Bei dieser Variante weist der Leiter 1' analog dem Leiter 1 lediglich eine einzige Umbiegung 2' auf. Ferner sind die Schenkel 2a', 2c' der Umbiegung 2' in der bereits beschriebenen Weise mit jeweils zwei voneinander beabstandeten Querstegen 24', 25' und 26', 27' versehen. Die Umbiegung 2' ist vollständig mit dem Kunststoffmaterial 3 umspritzt, welches die Wandung bildet. Diese Kunststoffwandung wird von einer steifen Kappe 5 umgriffen, die aus Metall, beispielsweise aus Stahl mit einem thermischen Ausdehnungskoeffizienten von α = 12 x 10⁻⁶ K⁻¹ sein kann.

Die Kappe 5 kann in einem Arbeitsgang beim Umspritzen des Leiters (Stanzgitters) 1' in den Verbund eingefügt werden oder nachträglich in Art eines Rahmens auf die Kunststoffwandung aufgesetzt werden. Durch die geringere thermische Ausdehnung des Kappenmaterials verglichen mit dem Kunststoffmaterial 3 bauen sich bei einer Temperaturerhöhung in den Kunststoffmaterialbereichen zwischen den Schenkeln 2a', 2c' der Umbiegung 2' und den Seitenwänden der Kappe 5 Druckkräfte F_{D} auf, die den innerhalb der Umbiegung auftretenden Druckkräften F_{D} entgegengerichtet sind und somit eine Abdichtung der Durchführung sowohl im Bereich der konvexen als auch der konkaven Leiterwandbereiche herbeiführen.

Die Abdichtung in der zweiten Ebene senkrecht zu der durch die Papierebene repräsentierten Leiterbahnebene wird in der bereits beschriebenen Weise durch das Zusammenwirken benachbarter Querstege 24', 25' und 26', 27' erreicht. Zur Erhöhung der Dichtwirkung können auch hier mehrere aneinandergereihte derartige Dichtzellen vorgesehen sein.

Die maximal erzielbare Dichtwirkung hängt u.a. von der Materialwahl bezüglich des Leiters 1', des Kunststoffs 3 und der Kappe 5 und insbesondere von der Kappensteifigkeit ab. Darüber hinaus wird sie durch die Geometrie der Durchführungsanordnung wesentlich beeinflußt. Die Dichtkraft ist umso höher, je größer die Umbiegungsweite s und die Umbiegungsamplitude t sind, da bei größerer Länge von s, t eine entsprechend größere absolute Dehnung dieser Bereiche erzielt wird, was wiederum entsprechend höhere Anpreßkräfte F_{D} verursacht.

Die Kappensteifigkeit kann auch durch konstruktive Maßnahmen, wie beispielsweise dem Vorhandensein eines Verbindungsteils 51 zwischen den Seitenwänden der Kappe 5, erhöht werden. Sie wird ferner durch die Kappenbreite b und die Kappenhöhe h beeinflußt.

Da die zwischen der Leiterumbiegung 2' und der Kappe 5 auftretenden Druckkräfte auch auf die Innenseite der Kappe 5 einwirken, wird auch die Kappe 5 nach dem bereits beschriebenen Mechanismus abgedichtet.

Fig. 6 zeigt eine zweite Ausführungsform einer erfindungsgemäßen Durchführungsanordnung. Der Leiter 100 ist als Rundteil ausgebildet und weist zwei in Axialrichtung beabstandet angeordnete Radialscheibenelemente 110, 120 auf. Jedes Radialscheibenelement 110, 120 ist in optionaler Weise mit mindestens zwei radial beabstandeten Umlaufstegen 111, 112 und 121, 122 ausgeführt. Die Umlaufstege 111, 112, 121, 122 stehen zu beiden Seiten über die Scheibenflächen der Radialscheibenelemente 110, 120 hervor. Der Leiter 100 ist gemäß der vorhergehenden Beschreibung in dem Kunststoffmaterial 3 eingebettet.

Eine Abdichtung in axialer Richtung des Leiters 100 wird durch die Radialscheibenelemente 110, 120 gewährleistet, da sich nach dem bereits beschriebenen Prinzip im dazwischenliegenden Kunststoffmaterialbereich eine axial in Richtung der Doppelpfeile wirkende Dichtkraft F_{D} aufbaut. Die Höhe der Dichtkraft F_{D} steigt mit dem axialen Abstand der Radialscheibenelemente 110, 120. Die optionalen Umlaufstege 111, 112, 121, 122 stellen eine zusätzliche Abdichtung der Radialscheibenelemente 110, 120 in radialer Richtung sicher. Die Höhe der radialen Dichtkraft ist proportional dem Abstand der Umlaufstege 111, 112, 121, 122 von der Leiterachse und proportional dem Radialabstand ΔR der Umlaufstege 111, 112 sowie 121, 122 untereinander.

In den Fig. 1 - 6 wurde die Erfindung anhand einer Temperaturerhöhung und eines thermischen Ausdehnungskoeffizientens von Metall kleiner als der von Kunststoff erläutert. Das erfindungsgemäße Prinzip funktioniert jedoch auch bei einer Temperaturerniedrigung und/oder einem thermischen Ausdehnungskoeffizienten von Metall größer als der des Kunststoffs. In diesem Fall erfolgt die Abdichtung nicht im konvexen, sondern im konkaven Bereich einer Umbiegung.

Fig. 7 zeigt eine Teilschnittdarstellung eines Kraftfahrzeug-Steuergerätes zum Einbau in ein Motor- oder Getriebegehäuse. Das Steuergerät weist eine Aluminium-Grundplatte 6 auf, auf der ein Keramik-Schaltungsträger 7 befestigt ist. Auf dem Schaltungsträger 7 ist eine Steuerelektronik realisiert.

Der Seitenwandbereich des Kraftfahrzeug-Steuergerätes ist in dem hier dargestellten Beispiel durch die in Fig. 5 gezeigte verkapselte Wandungsdurchführung realisiert. Ein Gehäusedeckel 9 des Steuergerätes ist über eine Formdichtung 15 flüssigkeitsdicht mit der Oberseite der Kappe 5 gekoppelt.

In analoger Weise können auch die in den anderen Fig. 2 - 6 gezeigten Anordnungen sowie Kombinationen derselben zur dichten Durchführung von strom- und signalführenden Leitungen in ein Kraftfahrzeug-Steuergerät eingesetzt werden.

## Patentansprüche

1. Anordnung zum dichten Durchführen eines metallischen Leiters (1, 1', 10, 100) durch eine Kunststoffwandung (3), bei der
- der Leiter (1, 1', 10, 100) in die Kunststoffwandung eingebettet (3) ist, und
- das Kunststoffmaterial und das Metallmaterial des Leiters unterschiedliche thermische Ausdehnungskoeffizienten aufweisen,
**dadurch gekennzeichnet,**
- **daß** der Leiter (1, 1', 10, 100) einen solcherart gebogenen Verlauf aufweist, daß bei einer Temperaturänderung mindestens ein Abschnitt im Durchführungsweg verbleibt, in welchem entgegengesetzt gerichtete Abdichtkräfte (F_{D}) auf den Leiter (1, 1', 10, 100) einwirken.

2. Anordnung nach Anspruch 1,
**dadurch gekennzeichnet,**
- **daß** der Verlauf des Leiters (1, 1', 10, 100) in einer ersten Ebene mindestens zwei entgegengesetzt gekrümmte Umbiegungen (21, 22, 23) umfaßt.

3. Anordnung nach Anspruch 1,
**dadurch gekennzeichnet,**
- **daß** der Verlauf des Leiters (1, 1', 10, 100) in einer ersten Ebene eine Umbiegungen (2') umfaßt, und
- **daß** die Umbiegung (2') in ihrem Außenbereich zumindest abschnittsweise von einem starren Gegendruckelement, insbesondere einer Kapsel (5), umgeben ist.

4. Anordnung nach Anspruch 2 oder 3,
**dadurch gekennzeichnet,**
- **daß** der Leiter (1, 1', 10, 100) mit mindestens zwei in Axialrichtung beabstandet angeordneten Paaren (24, 25, 27, 28) aus voneinander weggerichteten Dichtvorsprüngen (24a, 24b) ausgestattet ist, die sich in einer Richtung senkrecht zu der ersten Ebene erstrecken.

5. Anordnung nach einem der vorhergehenden Ansprüche,
**dadurch gekennzeichnet,**
- **daß** die Umbiegung oder die Umbiegungen (2, 21, 22, 23) einen rechteckförmigen Verlauf aufweisen.

6. Anordnung nach einem der vorhergehenden Ansprüche,
**dadurch gekennzeichnet,**
- **daß** der Leiter (1, 1', 10) ein rechteckförmiges Querschnittprofil aufweist.

7. Anordnung zum dichten Durchführen eines metallischen Leiters (1, 1', 10, 100) durch eine Kunststoffwandung (3), bei der
- der Leiter (100) mit zumindest zwei unter axialem Abstand angeordneten Radialscheibenelementen (110, 120) versehen ist,
**dadurch gekennzeichnet,**
- **daß** jedes Radialscheibenelement (110, 120) an beiden Seiten mit jeweils zwei erhabenen, radial beabstandeten Umlaufstegen (111, 112, 121, 122) ausgeführt ist.

8. Anordnung nach einem der vorhergehenden Ansprüche,
**dadurch gekennzeichnet,**
- **daß** mehrere Leiter (1, 1', 10, 100) in Form eines Stanzgitters zusammengefaßt sind.

9. Verfahren zur Herstellung einer dichten Durchführung eines metallischen Leiters (1, 1', 10, 100) durch eine Kunststoffwandung (3), wobei das Kunststoffmaterial und das Metallmaterial des Leiters unterschiedliche thermische Ausdehnungskoeffizienten aufweisen, bei welchem
- der Leiter (1, 1', 10, 100) insbesondere durch Umspritzen in die Kunststoffwandung (3) eingebettet wird,
**dadurch gekennzeichnet,**
- **daß** dem Leiter (1, 1', 10, 100) zuvor durch einen Biegevorgang eine solche Form verliehen wird, daß nach der Einbettung in das Kunststoffmaterial (3) bei einer Temperaturänderung mindestens ein Abschnitt im Durchführungsweg verbleibt, in welchem entgegengesetzt gerichtete Abdichtkräfte (F_{D}) auf den Leiter (1, 1', 10, 100) einwirken.

## Claims

1. Arrangement for providing a sealed passage for a metallic conductor (1, 1', 10, 100) through a plastic wall (3), whereby
- the conductor (1, 1', 10, 100) is embedded in the plastic wall (3), and
- the plastic material and the metal material of the conductor exhibit different coefficients of thermal expansion,
**characterised in that**
- the conductor (1, 1', 10, 100) exhibits a track which is bent in such a manner that when a change in temperature occurs at least one section remains in the through-passage path in which sealing forces (F_{D}) acting in opposite directions act on the conductor (1, 1', 10, 100).

2. Arrangement according to Claim 1, **characterised in that**
- in a first plane the track of the conductor (1, 1', 10, 100) includes at least two bends (21, 22, 23) curved in opposite directions.

3. Arrangement according to Claim 1, **characterised in that**
- in a first plane the track of the conductor (1, 1', 10, 100) includes one bend (2'), and
- the bend (2') is surrounded in its outer area at least in sections by a rigid counter-pressure element, in particular by a casing (5).

4. Arrangement according to Claim 2 or 3, **characterised in that**
- the conductor (1, 1', 10, 100) is equipped with at least two pairs (24, 25, 27, 28), arranged with an intervening gap in the axial direction, of sealing projections (24a, 24b) facing in opposite directions, which extend in a direction perpendicular to the first plane.

5. Arrangement according to one of the preceding claims, **characterised in that**
- the bend or bends (2, 21, 22, 23) exhibit a rectangular track.

6. Arrangement according to one of the preceding claims, **characterised in that**
- the conductor (1,1', 10) exhibits a rectangular cross-sectional profile.

7. Arrangement for providing a sealed passage for a metallic conductor (1, 1', 10, 100) through a plastic wall (3), whereby
- the conductor (100) is provided with at least two radial disk elements (110, 120) arranged with an axial spacing,
**characterised in that**
- each radial disk element (110, 120) is designed such that each of its two sides has two raised planetary flanges (111, 112, 121, 122), arranged with a radial spacing.

8. Arrangement according to one of the preceding claims, **characterised in that**
- a plurality of conductors (1, 1', 10, 100) is combined in the form of a stamped grid.

9. Method for manufacturing a sealed passage for a metallic conductor (1, 1', 10, 100) through a plastic wall (3), whereby the plastic material and the metal material of the conductor exhibit different coefficients of thermal expansion, in which method
- the conductor (1, 1', 10, 100) is embedded in the plastic wall (3) by means of extrusion coating in particular,
**characterised in that**
- the conductor (1, 1', 10, 100) is previously given such a shape by means of a bending operation that, after it has been embedded in the plastic material (3), when a change in temperature occurs at least one section remains in the through-passage path in which sealing forces (F_{D}) acting in opposite directions act on the conductor (1, 1', 10, 100).

## Revendications

1. Dispositif permettant de faire passer de manière étanche un conducteur métallique (I, I', 10, 100) à travers une paroi en matière plastique (3), dans lequel
- le conducteur (I, I', 10, 100) est enrobé dans une paroi en matière plastique (3) et
- la matière plastique et le métal du conducteur présentent des coefficients de dilatation thermique différents,
**caractérisé en ce que**
- le conducteur (I, I', 10, 100) présente une allure coudée de telle manière que, lors d'un changement de température, il reste au moins une partie dans le parcours du dispositif de traversée, dans laquelle des forces d'étanchement (F_{D}) orientées de manière opposée agissent sur le conducteur (I, l', 10, 100).

2. Dispositif selon la revendication 1,
**caractérisé en ce que**
- l'allure du conducteur (I, I', 10, 100) comprend, dans un premier plan, au moins deux courbures à coudes opposés (21, 22, 23).

3. Dispositif selon la revendication 1,
**caractérisé en ce que**
- l'allure du conducteur (I, I', 10, 100) comprend, dans un premier plan, une courbure (2'), et
- la courbure (2') est entourée dans sa zone extérieure, au moins partiellement, d'un élément de contre-pression rigide, en particulier d'une capsule (5).

4. Dispositif selon la revendication 2 ou 3,
**caractérisé en ce que**
- le conducteur (I, I', 10, 100) est équipé d'au moins deux paires (24, 25, 27, 28) de saillies d'étanchéité (24a, 24b) d'orientation opposée, s'étendant perpendiculairement au premier plan, lesdites paires étant disposées dans le sens axial à une distance donnée l'une de l'autre.

5. Dispositif selon l'une des revendications précédentes, **caractérisé en ce que**
- la courbure ou les courbures (2, 21, 22, 23) présentent une allure de forme rectangulaire.

6. Dispositif selon l'une des revendications précédentes, **caractérisé en ce que**
- le conducteur (I, I', 10) présente un profil de section de forme rectangulaire.

7. Dispositif permettant de faire passer de manière étanche un conducteur métallique (I, l', 10, 100) à travers une paroi en matière plastique (3), dans lequel
- le conducteur (100) est pourvu d'au moins deux éléments de disque radiaux (110, 120) disposés à une distance axiale donnée l'un de l'autre,
**caractérisé en ce que**
- chaque élément de disque radial (110, 120) est équipé, sur les deux côtés, respectivement de deux éléments circonférentiels de renfort (111, 112, 121, 122) protubérants, séparés radialement l'un de l'autre.

8. Dispositif selon l'une des revendications précédentes, **caractérisé en ce que**
- plusieurs conducteurs (I, I', 10, 100) sont regroupés sous la forme d'un grillage estampé.

9. Procédé de fabrication d'un dispositif permettant de faire passer de manière étanche un conducteur métallique (I, I', 10, 100) à travers une paroi en matière plastique (3), la matière plastique et le métal du conducteur présentant des coefficients de dilatation thermique différents, dans lequel
- le conducteur (I, I', 10, 100) est enrobé, notamment par surmoulage, dans une paroi en matière plastique (3),
**caractérisé en ce que**
- l'on confère préalablement au conducteur (I, I', 10, 100), par flexion, une forme telle qu'après son encastrement dans la matière plastique (3), lors d'un changement de température, il reste au moins une partie du parcours du dispositif de traversée, dans laquelle des forces d'étanchement (F_{D}) orientées de manière opposée agissent sur le conducteur (I, I', 10, 100).
